# EUROPÄISCHE PATENTSCHRIFT

(11) **EP 4 509 253 B1**
(45) Veröffentlichungstag und Bekanntmachung des Hinweises auf die Patenterteilung: **20.05.2026**
(21) Anmeldenummer: 23192185.9
(22) Anmeldetag: 18.08.2023
(51) Int. Cl.: B23K 1/20

(54) **VERFAHREN ZUR ÜBERWACHUNG EINES FLUSSMITTELAUFTRAGES, COMPUTERPROGRAMM UND COMPUTERSYSTEM**
METHOD FOR MONITORING A FLUX APPLICATION, COMPUTER PROGRAM AND COMPUTER SYSTEM
PROCÉDÉ DE SURVEILLANCE D'UNE TÂCHE DE FLUX, PROGRAMME INFORMATIQUE ET SYSTÈME INFORMATIQUE

(43) Veröffentlichungstag der Anmeldung: 19.02.2025
(73) Patentinhaber: Siemens Aktiengesellschaft, 80333 München (DE)
(72) Erfinder: Blank, Rene, 12249 Berlin (DE); Hanisch, Michael, 16540 Hohen Neuendorf (DE); Jarchoff, Kay, 13347 Berlin (DE); Matiwe, Marco, 12555 Berlin (DE); Müller, Bernd, 16259 Falkenberg (DE); Sommerfeld, Dennis, 12347 Berlin (DE); Wittreich, Ulrich, 16727 Velten (DE)
(74) Vertreter: Siemens Patent Attorneys

(56) Entgegenhaltungen:
- US-A1- 2020 170 155

## Beschreibung

Die Erfindung betrifft ein Verfahren zur Überwachung eines Flussmittelauftrags mit den Merkmalen des Patentanspruchs 1.

Bei Lötprozessen, beispielsweise in Wellenlötanlagen oder Selektivlötanlagen, wird vor dem Lötprozess die Lötstelle selektiv mit einem Flussmittel versehen. Dieser Prozess erfolgt hochautomatisiert, dabei werden die einzelnen zu benetzenden Oberflächen einer Leiterplatte gezielt mit einem Flussmittelstrahl für kurze Zeit besprüht, sodass an den erforderlichen Lötstellen die entsprechende Flussmittelmenge vorherrscht. Für die Qualität des Lötprozesses ist es allerdings von Bedeutung, dass die vorhandene Menge an Flussmittel an der richtigen Stelle genau dosiert ist. Dies betrifft sowohl die Position des Flussmittelauftrags als auch die Menge des aufgetragenen Flussmittels, die auf die Leiterplatte an der entsprechenden Position appliziert wird. Eine verfahrensbegleitende Überprüfung des Flussmittelauftrages auf dem Produkt ist derzeit nicht befriedigend möglich, sodass Schwankungen im Flussmittelauftrag zu Lötproblemen und zu Qualitätseinbußen führen können.

Aktuelle Überprüfungsmöglichkeiten für den Flussmittelauftrag sind entweder stichprobenartige Überprüfungen mit speziellen Produkt-Dummys, dabei handelt es sich um Trägerplatten mit Bohrungen auf der Oberseite und einem dort applizierten Indikatorpapier. Alternativ können auch Detektoren einer Unterbrechung eines Lichtstrahls mittels zum Beispiel Laserlichtschranken den Flussmittelauftragstrahl überprüfen. Eine Detektion des Flussmittels auf den zu fertigenden Produkten, also auf einer Leiterplattenoberfläche, ist wegen des transparenten Erscheinungsbildes des Flussmittels mit visuellen Verfahren nur schwer möglich. Eine kontinuierliche automatisierte und fertigungsbegleitende Überprüfung der Transferqualität auf Produktniveau ist daher derzeit nur unbefriedigend zu gewährleisten.

In der US 2020/170155 A1 ist ein Verfahren zur Überwachung eines Flussmittelauftrags in einem Lötprozesse unter Zuhilfenahme einer Wärmebildkamera beschrieben.

Die Aufgabe der Erfindung besteht darin, ein Verfahren zur Überwachung eines Flussmittelauftrags in einem Lötprozess bereitzustellen, durch das vor dem eigentlichen Lötprozess Mängel bei der Flussmittelauftragung erkannt werden können.

Die Lösung der Aufgabe besteht in einem Verfahren zur Überwachung eines Flussmittelauftrags mit den Merkmalen des Patentanspruchs 1.

Das erfindungsgemäße Verfahren zur Überwachung eines Flussmittelauftrags in einem Lötprozess gemäß Patenanspruch 1 umfasst dabei folgende Schritte:
- festlegen von Flussmittelbenetzungsflächen in Bezug auf eine Abbildung einer Applikationsoberfläche,
- erzeugen einer Thermografie-Aufnahme von der selektiv mit flüssigem Flussmittel versehenen Applikationsoberfläche
- festlegen von Justierpunkten auf der Applikationsoberfläche, die auf der Abbildung und auf der Thermografie-Aufnahme identifizierbar sind,
- überlagern der Abbildung und der Thermografie-Aufnahme anhand der Justierpunkte
- vergleichen der Position von Temperaturanomalien auf der Applikationsoberfläche, die mittels der Thermografie-Aufnahme identifiziert werden, mit der Position der Flussmittelbenetzungsflächen auf der Abbildung.

Das beschriebene Verfahren weist den Vorteil auf, dass die Applikationsoberfläche, also i. d. R. die Oberfläche einer mit Lötpunkten zu versehenen Leiterplatte, nach dem Aufbringen des Flussmittels thermografisch untersucht wird. Es hat sich herausgestellt, dass nach einer bestimmten Zeit nach dem Auftragen an den Flussmittelbenetzungsflächen Temperaturanomalien gegenüber der Umgebungsfläche auftreten. Diese Temperaturanomalien, die im Weiteren noch genauer definiert werden, resultieren aus der Verdampfungsenthalpie, die beim partiellen Verdampfen von Flussmittelbestandteilen, insbesondere Lösungsmittel des Flussmittels auftreten und der benetzten Oberfläche Wärme entziehen. Aus diesem Grund sind die benetzten Oberflächen der Applikationsoberflächen kühler als die nicht benetzten Oberflächen. Vergleicht man die Thermografie-Aufnahme mit einer vor der Benetzung durchgeführten Abbildung (einer fotographischen Abbildung oder auch einem digitalen Zwilling der Abbildung aus einem CAD-System), so können mittels fester Punkte, die hier als Justierpunkte bezeichnet werden, festgestellt werden, ob die bestimmten, festgelegten Flussmittelbenetzungsflächen auch tatsächlich mit Flussmittel versehen sind und auch ausreichend versehen sind, wenn dort die Temperaturen niedriger sind als an den übrigen Flächen der Applikationsoberfläche.

Auf diese Weise kann gezielt Einfluss auf den Lötprozess genommen werden und somit die Qualitätssicherung des Lötprozesses gegenüber dem Stand der Technik verbessert werden.

Für die in den Patentansprüchen verwendeten Begriffe sind die folgenden Definitionen angegeben:

### Definitionen:

Lötprozess: Unter einem Lötprozess werden alle Fügeverfahren verstanden, bei denen mittels eines Zusatzstoffes (Lot) durch eine Wärmebehandlung eine Verbindung zwischen zwei metallischen Komponenten hergestellt wird. Dabei schmelzen die metallischen Komponenten in der Regel in der Tiefe nicht auf, in ihren Oberflächenbereichen finden jedoch Legierungsprozesse statt, so dass es zu einer stoffschlüssigen Verbindung kommt. Hierzu wird unterstützend ein Flussmittel eingesetzt, das insbesondere reduzierend auf die Oberflächen der zu lötenden metallischen Komponenten wirkt und somit diese Oberflächen von Oxidschichten befreit. Flussmittel können zudem auch noch den beschriebenen Legierungsprozess als Aktivatoren unterstützen. Daher können Flussmittel auch mehrere chemische Bestandteile wie Säuren und Chloride umfassen. Unter diese Definition können auch bestimmte Schweißprozesse fallen, was dann zutrifft, wenn gleichzeitig neben einem Zusatzstoff (Lot) auch ein Flussmittel verwendet wird.

Die Abbildung der Applikationsoberfläche, die in der Regel eine Leiterplattenoberfläche ist, kann eine Konstruktionsdarstellung beispielsweise aus einem CAD-Programm sein, sie kann aber auch eine fotographische Abbildung der real existierenden Leiterplatte bzw. deren Oberfläche sein. Die Abbildung ist in einem Computersystem, beispielsweise in einer Anlagensteuerung wie beispielsweise in einer Siemens S7 1500 und/oder in ihren Peripheriegeräte hinterlegt oder sie wird direkt nach der Aufnahme dort hinterlegt. In der Regel wird die Abbildung in Form von Bildpunkten in das Computersystem bzw. in die Anlagensteuerung übertragen. Das gleiche gilt auch für die Thermographie-Aufnahme, die bevorzugt in Form einer Infrarot-Aufnahme durchgeführt wird. Auch einzelne punktförmige Temperaturmessungen, beispielsweise mit einem Thermoelement sind Thermographie-Aufnahmen, wenn der betrachtete Punkt bezüglich der Abbildung lokalisierbar ist.

Justierpunkte sind geometrische Gebilde (nicht nur Punkte im mathematischen Sinne) auf der Applikationsoberfläche, die ausreichend charakteristisch sind, um eine eindeutige Zuordnung der Darstellung der Abbildung und der Thermographie-Aufnahme zu gewährleisten. Dabei sind zur eindeutigen Justierung bevorzugt mindestens zwei Justierpunkte vorgesehen. Dabei können beispielsweise die Flussmittelbenetzungsflächen bereits als Justierpunkte dienen. Anhand der festgelegten Justierpunkte können die Abbildung der Leiterplattenoberfläche und die Thermographie-Aufnahme übereinandergelegt, das heißt überlagert werden. Dabei wird der Begriff Überlagern im übertragenen Sinne verwendet, analog zu einem Bild und einer transparenten Folie. Bei rein digital vorliegenden Bildern besteht das Überlagern in einem elektronischen Vergleichen, beispielsweise durch ein Bildanalyse-Programm, wobei die Aufnahme und die Abbildung anhand der festgelegten Justierpunkte mittels einzelner Bildpunkte oder Bildpunktcluster ausgewertet werden.

Temperaturanomalien sind auf der Thermographie-Aufnahme sichtbare Punkte oder Flächen, die gegenüber der Umgebungsfläche einen Temperaturunterschied aufweisen. Dabei tritt in der Regel innerhalb einer Temperaturanomalie nicht zwingend eine konstante Temperatur auf, vielmehr liegt dort eine Temperaturintervall vor, das sich mit einem Temperaturintervall, das die Umgebungsflächen aufweisen, nicht schneidet. Daher ist für die Bestimmung einer Grenze zwischen der Temperaturanomalie und der Umgebungsfläche die Festlegung einer Schwelltemperatur also ein Temperaturschwellwert zweckmäßig.

Unter dem Begriff Zeitintervall wird der Zeitraum vom Aufbringen des Flussmittels auf die Flussmittelbenetzungsfläche bis zu einem definierten Zeitpunkt einer abschließenden Thermographie-Aufnahme verstanden. Da aber in diesem Zeitintervall mehrere Thermographie-Aufnahmen vorgenommen werden können (beispielsweise durch eine Infrarot-Videoaufnahme), kann es auch zweckmäßig sein, die Temperatur als Funktion der Zeit zu betrachten und mit einem empirisch bestimmten Temperatur-Zeit-Verlauf (Referenzverlauf) zu vergleichen. In diesem Fall wird unter dem Begriff Temperatur ein Punkt auf der Temperatur-Zeit-Kurve verstanden, beispielsweise auch der Endpunkt der Kurve. Hierfür ist es vorteilhaft, einen Toleranzbereich des Referenzverlaufs zu definieren. Dies kann beispielsweise eine oder zwei zum Referenzverlauf parallel verlaufende Kurven sein, in deren Bereich der betrachtete Temperatur Zeit-Verlauf liegen sollte. Der betrachtete Zeitverlauf der Temperatur-Zeit-Betrachtung entspricht dem Zeitintervall. Dabei ist es nicht zwingend notwendig, dass innerhalb des Zeitintervalls mehrere Thermographie-Aufnahmen bewertet werden.

Ein digitaler Zwilling ist eine digitale Repräsentation eines materiellen oder immateriellen Objekts oder Prozesses aus der realen Welt in der digitalen Welt. Digitale Zwillinge ermöglichen einen übergreifenden Datenaustausch. Sie sind dabei mehr als reine Daten und bestehen aus Modellen des repräsentierten Objekts oder Prozesses und können daneben Simulationen, Algorithmen und Services enthalten, die Eigenschaften oder Verhalten des repräsentierten Objekts oder Prozesses beschreiben, beeinflussen, oder Dienste darüber ermöglichen.

In einer bevorzugten Ausgestaltungsform der Erfindung wird ein Temperaturschwellwert für die Temperaturanomalien festgelegt. Dies erleichtert es für die Auswertung der Temperaturanomalien, diese gegenüber den Umgebungsflächen der Applikationsoberfläche abzugrenzen.

In einer weiteren bevorzugten Ausgestaltungsform der Erfindung wird eine Maßnahme zur Beeinflussung des Lötprozesses eingeleitet, wenn innerhalb eines Zeitintervalls nach Aufbringen des Flussmittels eine mittels der Thermografie-Aufnahme bestimmte Temperatur an einer Flussmittelbenetzungsfläche jenseits des Temperaturschwellwertes liegt. Auf diese Weise kann durch direktes Eingreifen in den Lötprozess und in den vorgelagerten Flussmittelaufbringungsprozess die Qualität der fertigen Lötstellen verbessert werden.

Eine Maßnahme kann dabei sein, ein erneutes Auftrages des Flussmittels an der detektierten Flussmittelbenetzungsfläche einzuleiten. Eine andere vorteilhafte Maßnahme kann darin bestehen, einen Reinigungsprozess von Flussmittel-Auftragsdüsen vorzunehmen.

Die Temperatur innerhalb der Temperaturanomalie kann zu einem festen Zeitpunkt nach dem Aufsprühen des Flussmittels gemessen werden. Es ist jedoch auch zweckmäßig, die Temperatur als Funktion der Zeit zu betrachten. Auf diese Weise kann das Verdampfungsverhalten des aufgebrachten Flussmittels bzw. Bestandteile des Flussmittels genauer beobachtet werden und somit stabilere Informationen über die tatsächlich aufgebrachten Flussmittelmenge an die bestimmte Stelle ermittelt werden. Auf diese Weise kann eine noch bessere Qualitätssicherung erfolgen.

Hierzu ist es wiederum zweckmäßig, dass ein Referenzverlauf einer Temperatur-Zeit-Kurve an einer definierten Flussmittelbenetzungsfläche Z aufgenommen wird und mit dem betrachteten Temperatur-Zeit-Verlauf verglichen wird. D. h. ein empirisch bestimmter Referenzverlauf der Temperaturentwicklung mit der Zeit, bei dem die aufgebrachte Flussmittelmenge genau bekannt ist, kann dazu dienen, den aktuell gemessenen Temperatur-Zeit-Verlauf mit einer bestimmten Flussmittelmenge in Verbindung zu bringen. Hierfür ist es wiederum zweckmäßig, wenn ein Toleranzbereich des Referenzverlaufs definiert wird. Die Maßnahme zur Beeinflussung des Lötprozesses wird erst dann eingeleitet, wenn der betrachtete Temperatur-Zeit-Verlauf außerhalb dieses Toleranzbereichs liegt.

Die Maßnahme erfolgt insbesondere erst dann, wenn die Temperatur an der Flussmittelbenetzungsfläche über dem Temperaturschwellwert liegt. Wenn dies der Fall ist, wurde zu wenig Flussmittel aufgetragen, da wie bereits erwähnt, die Verdampfungsenthalpie von Flussmittelbestandteilen zu einer lokalen Abkühlung der Applikationsoberfläche führt. Ist diese Abkühlung aufgrund eines zu geringen Flussmittelauftrags nicht erfolgt, bleibt die Temperatur höher als beispielsweise der Temperaturschwellwert.

In einer weiteren Ausgestaltungsform der Erfindung ist die Thermografie-Aufnahme so gestaltet, dass eine Mehrzahl von derartigen Aufnahmen innerhalb eines Zeitraums erfasst werden. Dies bedeutet, dass i. d. R. eine Videoaufnahme erfolgt. Insbesondere kann dies mittels einer Infrarot-Videokamera erfolgen. Im Gegenzug kann die Abbildung eine lichtfotografische Aufnahme der zu beobachtenden Applikationsoberfläche sein. Diese lichtfotografische Aufnahme kann an der aktuellen Applikationsoberfläche nach dem Flussmittelauftrag vorgenommen werden und dann in digitaler Form in ein Computerprogramm bzw. in ein Computersystem eingebracht werden.

Weitere Beispiele und weitere vorteilhafte Merkmale der Erfindung werden anhand der folgenden Figuren näher erläutert. Dabei handelt es sich um rein exemplarische Ausgestaltungsformen, die keine Einschränkung des Schutzbereichs darstellen.

Dabei zeigen:
Figur 1 einen schematischen Ablaufplan des Verfahrens und des Lötprozesses,
Figur 2a und c Thermografie-Aufnahmen der Applikationsoberfläche,
Figur 2b eine Abbildung der Applikationsoberfläche und
Figur 3 eine Zeit-Temperatur-Kurve von Temperaturanomalien auf der Applikationsoberfläche.

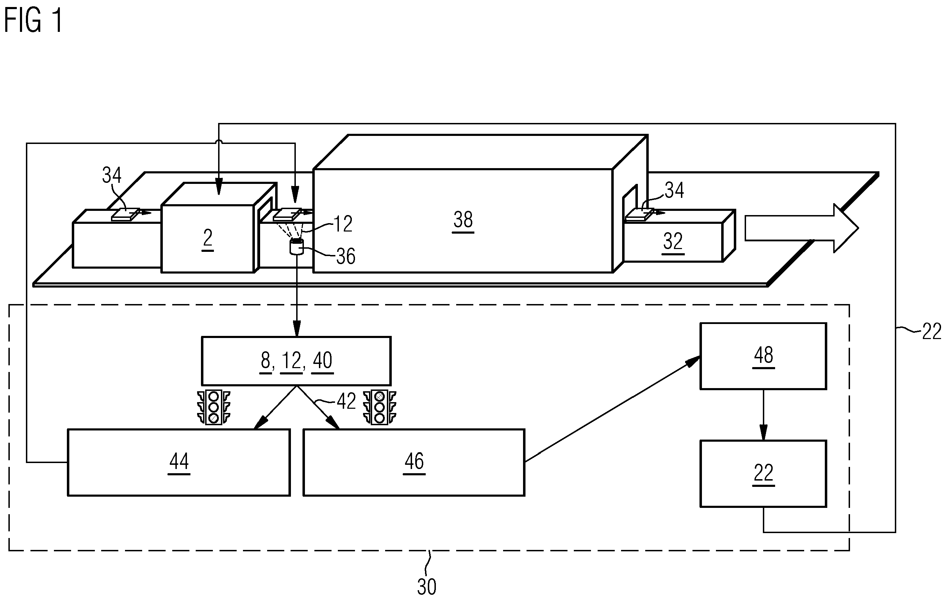

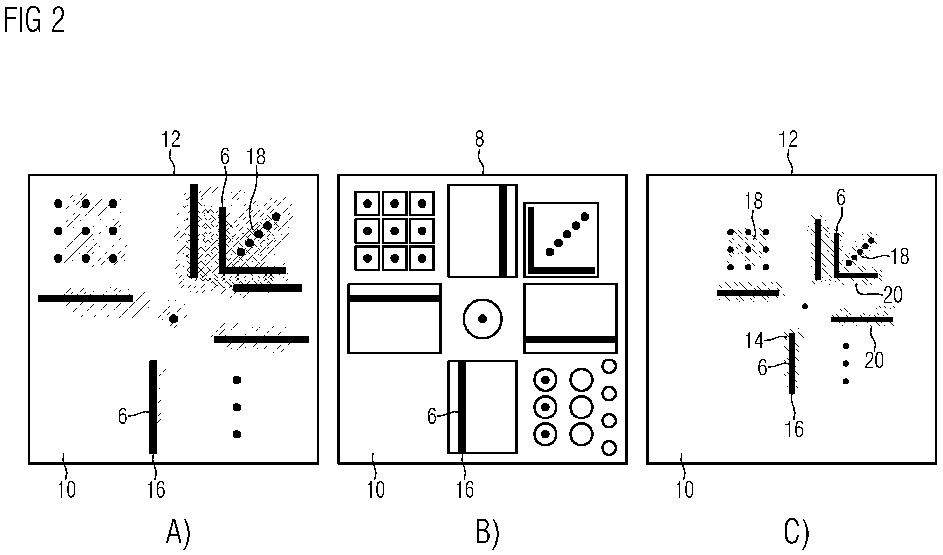

In Figur 1 ist eine schematische Darstellung eines Lötverfahrens und des Verfahrens zur Überwachung eines Flussmittelauftrags in einem Lötprozess gegeben. Beide Verfahren wirken ineinander, sodass die Qualitätssicherung des Lötverfahrens durch das Überwachungsverfahren beeinflusst ist. Zunächst ist ein Transportband 32 vorgesehen, auf dem eine Leiterplatte 34 mit einer Applikationsoberfläche 10 transportiert wird, wobei die Applikationsoberfläche 10 in diesem Fall eine Leiterplattenoberfläche 10 ist. Zunächst erfolgt in einem sogenannten Flux-Modul ein Flussmittelauftrag 2. Hierbei wird durch einen gerichteten Strahl, der in sehr kurzen Taktungen unterbrochen ist, ein Flussmittel 14 auf Flussmittelbenetzungsflächen 6 (in Figur 1 nicht sichtbar, siehe Figur 2) aufgespritzt. Hierbei ist eine hier nicht dargestellte Flussmitteldüse vorgesehen, durch die das Flussmittel 14 austritt. Die nicht dargestellte Flussmitteldüse kann mittels einer Steuerung, die beispielsweise integraler Bestandteil eines Computersystems 30 sein kann, in ihrem Winkel zur Leiterplattenoberfläche 10 bewegt werden. Ebenso kann durch diese beschriebene Steuerung der Flussmittelstrahl gezielt unterbrochen werden, sodass zum vorgesehenen Zeitpunkt das Flussmittel 14 am vorgesehenen Ort auf der Leiterplattenoberfläche 10, also auf den Flussmittelbenetzungsflächen, auftrifft.

Im Weiteren erfolgt nun das Verfahren zur Überwachung des Flussmittelauftrags 2. Hierzu wird eine Thermografie-Aufnahme 12 mittels einer Infrarotkamera 36 aufgenommen, wobei die Thermografie-Aufnahme 12 in ein Computersystem 30 integriert wird. In dem Computersystem 30 ist ferner eine Abbildung 8 der Leiterplattenoberfläche 10 hinterlegt. Diese Abbildung 8 kann beispielsweise ein Auszug aus einem CAD-System der Leiterplatte 34 sein, es kann jedoch auch zweckmäßig sein, gleichzeitig mit der Thermografie-Aufnahme 12 auch jeweils eine lichtfotografische Aufnahme der Leiterplattenoberfläche 10 vorzunehmen. In diesem Fall werden sowohl die lichtfotografische Aufnahme der Abbildung 8 als auch die Thermografie-Aufnahme 12 während des Prozesses in das Computersystem 30 eingegeben und digital verglichen.

Bei diesem digitalen Vergleich, der auch als Überlagerung der Abbildung 8 und der Aufnahme 12 bezeichnet wird, werden sowohl die Abbildung 8 als auch die Thermografie-Aufnahme 12 in einzelne Bildpunkte zerlegt und bezüglich vorgegebener Justierpunkte 16 verglichen. Die Justierpunkte 16 sind dabei charakteristische Punkte, die sowohl auf der Abbildung 8 als auch auf der Thermografie-Aufnahme 12 elektronisch identifizierbar sind. Dabei können zweckmäßige Justierpunkte 16 die Flussmittelbenetzungsflächen 6 sein. Die Flussmittelbenetzungsflächen 6 sind dadurch festgelegt, dass sich dort Lötpunkte befinden, die im weiteren Verfahrensablauf des Lötprozesses mit einem Lötmittel versehen werden. Das Flussmittel dient dazu, diese Flächen vor dem Löten chemisch zu reduzieren, sodass an dieser Stelle keine Oxydationsschichten, die die Lötverbindung beeinträchtigen könnten, an der Oberfläche vorherrschen.

Es hat sich herausgestellt, dass durch das Aufbringen des Flussmittels 14 ein Verdampfungsprozess der leicht flüchtigen Substanzen der Flussmittels 14 eine lokale Abkühlung der Leiterplattenoberfläche 10 auftritt. Diese lokale Abkühlung ist durch die Verdampfungsenthalpie begründet, die der Leiterplattenoberfläche 10 genau an der Stelle der Flussmittelbenetzungsfläche 6 Wärme lokal entzieht. Durch die Thermografie-Aufnahme 12, die in der Regel in Form einer Infrarotaufnahme vorliegt, kann diese lokale Abkühlung auf der Leiterplattenoberfläche 10 in Form von Temperaturanomalien beobachtet werden. Auf die Definition und die Auswertung dieser Temperaturanomalien 18 wird im Weiteren noch eingegangen werden.

Diese beschriebene Überlagerung der Aufnahme 12 und der Abbildung 8 erfolgt in dem bereits erwähnten Computersystem 30. Dieses Computersystem 30 kann dabei einen Computer sowie eine Datenbank enthalten. Ferner kann das Computersystem 30 eine Prozesssteuerungseinheit wie beispielsweise eine Siemens Simatic S 7 1500 enthalten. Diese Steuereinrichtung, die hier nicht explizit dargestellt ist, steuert den Prozess und erhält aus anderen Komponenten des Computersystems 30 Informationen zur Steuerung. Es ist auch möglich, die Überlagerung 40 direkt in der Steuerung vorzunehmen. Ferner kann es auch zweckmäßig sein, eine Cloud-basierte Steuerung für den Lötprozess 4 und für das beschriebene Verfahren zur Überwachung anzuwenden. In diesem Fall wäre das Computersystem 30 nicht oder nur teilweise in räumlicher Nähe des Lötprozesses 4 angeordnet.

Mittels der Überlagerung 40 wird im Computersystem 30 anhand von ermittelten Referenzdaten, auf die ebenfalls noch näher eingegangen wird, berechnet, ob die Temperaturanomalien 18 einem befriedigenden Auftrag an Flussmittel 14 entsprechen (Temperaturauswertung 42). Liegt eine positive Temperaturauswertung 44 vor, so wird der Lötprozess 4 fortgesetzt. In diesem Fall wird über das Transportband 32 die Leiterplatte 34 in die Lötanlage 38 eingebracht. Dabei kann es sich um eine Wellen-Lötanlage oder um eine Selektiv-Lötanlage handeln. Der Lötprozess wird wie geplant durchgeführt und anschließend wird die Leiterplatte 34 der weiteren Verwendung zugeführt. Sollte jedoch bei der Überlagerung 40 die Situation auftreten, dass die ermittelten Temperaturanomalien 18 nicht den Vorgaben entsprechen (negative Temperaturauswertung 46), so kann dies auf einen Qualitätsmangel beim Auftragen des Flussmittels 14 auf die definierten Flussmittelbenetzungsflächen 6 hindeuten.

In diesem Fall wird mittels des Computersystems 30 eine Datenanalyse 48 durchgeführt. Hierbei wird mittels der vorliegenden Informationen aus der Thermografie-Aufnahme 12, der Abbildung 8, aber auch mittels weiterer, bisher nicht erwähnter Prozessparameter wie beispielsweise die Funktionsweise der nicht dargestellten Flussmitteldüse ausgewertet. Dabei kann beispielsweise als Ergebnis stehen, dass die Flussmitteldüse verstopft ist oder der Druck des Flussmittelstrahls zu niedrig ist. Auch die Bewegungssteuerung der Flussmitteldüse kann fehlerhaft sein. Auf Basis dieser Informationen wird mittels der Datenanalyse 48 eine Maßnahme 22 ermittelt, die möglichen Qualitätsmängeln im Flussmittelauftrag entgegenwirkt. Diese Maßnahme 22 kann beispielsweise eine Reinigung der Flussmitteldüse oder eine Adaption der Steuerung der Flussmitteldüse sein. Ferner kann die Maßnahme auch darin bestehen, die betrachtete Leiterplatte aus dem Prozess auszuphasen und erneut mit Flussmittel 14 im Flussmittelauftragprozess 2 zu versehen.

In Figur 2 ist beispielhaft eine Leiterplattenoberfläche 10 dargestellt, die durch verschiedene Aufnahmen erstellt wurde. Dabei handelt es sich bei den Figuren 2a, 2b und 2c jeweils um denselben Ausschnitt der Leiterplattenoberfläche 10, wobei in Figur 2a eine Infrarotkamera zum Einsatz kommt. Somit handelt es sich hierbei um eine Thermografie-Aufnahme 12, die jedoch sehr kontrastreich ist. Es treten dabei Temperaturanomalien 18 auf, die jedoch zu ihrer Umgebung einen gewissen fließenden Übergang aufweisen. An den festgelegten Flussmittelbenetzungsflächen 6, die auch als Justierpunkte 16 dienen, ist auffällig, dass die Temperatur messbar geringer ist, als an den Umgebungsflächen. In Figur 2b ist die Abbildung 8 derselben Leiterplattenoberfläche gegeben, wobei es sich hier um einen Auszug aus dem CAD-Modell, das zur Konstruktion der Leiterplatte 34 erstellt wurde, handelt. Grundsätzlich wäre hierfür auch eine während des Prozesses ermittelte lichtfotografische Aufnahme zweckmäßig. Dies wäre insbesondere dann zweckmäßig, wenn durch den Prozess weitere Veränderungen zu erwarten wären, die mittels der rein errechneten CAD-Abbildung 8 nicht zu erkennen wären. Auch die Abbildung 8 enthält die beschriebenen Flussmittelbenetzungsflächen 6, die wiederum die Justierpunkte 16 darstellen. Da wie in Figur 2a dargestellt, die Übergänge der Thermografie-Aufnahme 12 fließend sind, ist es zweckmäßig, einen Temperaturschwellenwert 20 zu definieren, um eine scharfe Grenze für die Temperaturanomalie 18 darzustellen. In Figur 2c ist zu erkennen, dass die so geschärften Temperaturanomalien 18 insbesondere um die festgelegten Flussmittelbenetzungsfläche 6 ausgeprägt sind.

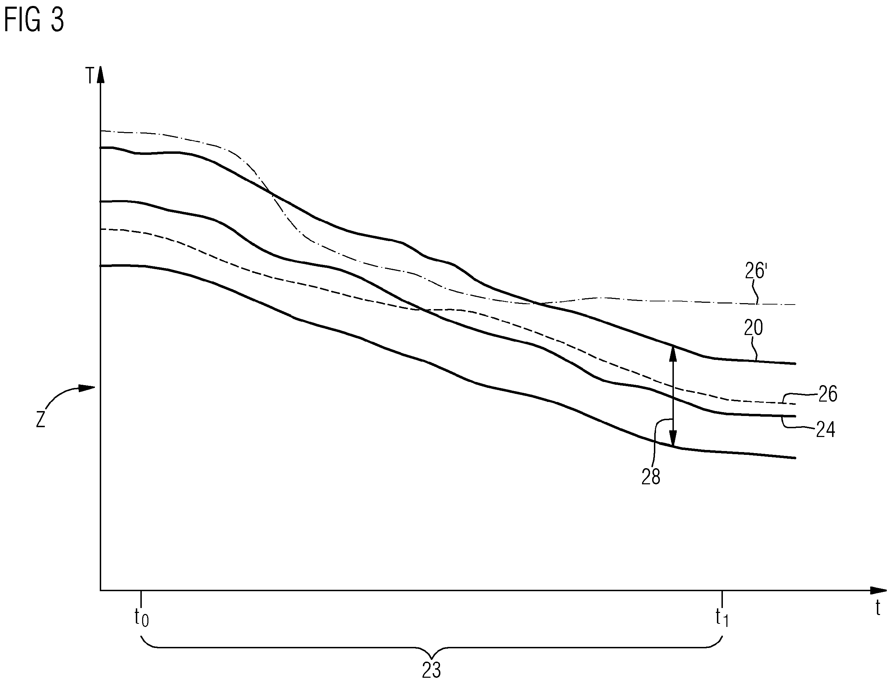

Nun kann durch die beschriebenen Thermografie-Aufnahmen 12 in Figur 2 zwar eine scharf eingegrenzte Temperaturanomalie 18 mittels des Temperaturschwellwerts 20 visuell dargestellt werden, für die Datenanalyse 48 und die elektronische Überlagerung 40 der Abbildung 8 und der Thermografie-Aufnahme 12 und für die weitere Prozesssteuerung des Flussmittelauftrages 2 bzw. des Lötprozesses ist es zweckmäßig, detailliertere Kriterien für die Qualität des Flussmittelauftrags 2 festzulegen. Hierzu gibt es mehrere zweckmäßige und mögliche Vorgehensweisen, beispielhaft soll an Figur 3 eine mögliche Vorgehensweise zur Auswertung beschrieben werden. Anhand von dem Punkt Z, einer beispielhaften Flussmittelbenetzungsfläche in Figur 2b wird die dort aufgenommene Temperatur in Figur 3 in Abhängigkeit von der Zeit beschrieben.

In Figur 3 ist ein Zeit-Temperatur-Diagramm am Punkt Z aus Figur 2 gegeben. Hierbei ist auf der Zeitachse t der Punkt t₀ und der Punkt t₁ festgelegt. Der Punkt t₀ ist der Zeitpunkt, bei dem das Flussmittel 14 auf die Flussmittelbenetzungsfläche 6, also hier auf den Punkt Z, aufgespritzt wird. Der Zeitpunkt t₁ ist der Betrachtungszeitpunkt. Der Zeitraum zwischen t₀ und t₁ wird als Zeitintervall 23 betrachtet. Nun ist es möglich, lediglich einen singulären Zeitpunkt zu t₁ oder den Temperaturverlauf an der Stelle Z während des Temperaturintervalls 23 zu betrachten.

Betrachtet man den Temperaturverlauf während des Zeitintervalls 23, so ist es zweckmäßig, einen Referenzverlauf 24 aufzunehmen, bei dem mittels Prozessauswertung ein qualitativ hochwertiger Auftrag an Flussmittel 14 erfolgt ist. Es ist zweckmäßig, um den Referenzverlauf 24 einen Toleranzbereich 28 zu definieren, durch den sich eine obere und untere Begrenzungslinie zum Referenzverlauf 24 ergibt. Bei der Betrachtung nur eines singulären Zeitpunktes handelt es sich um eine obere und untere Begrenzungstemperatur zu diesem Zeitpunkt. Der bezüglich der Temperaturachse T obere Verlauf des Toleranzbereiches 28 stellt dabei bevorzugt den Temperaturschwellwert 20 in Abhängigkeit von der Zeit t dar.

Betrachtet man nun den tatsächlich vorliegenden Temperatur-Zeit-Verlauf im Zeitintervall 23, so sollte dieser Verlauf 26 möglichst im Toleranzbereich 28 um den Referenzverlauf 24 liegen. In diesem Fall wären die Qualitätskriterien für das Aufbringen des Flussmittels 14 erfüllt und die Leiterplatte würde (wenn diese Qualitätsbedingungen für alle Flussmittelbenetzungsflächen 6 ausreichend sind) dem weiteren Lötprozess zugeführt werden (positive Temperaturauswertung 54 in Fig. 1). Sollte jedoch ein betrachteter Temperatur-Zeit-Verlauf 26' außerhalb des Toleranzbereiches 28 liegen, so kann wie bezüglich Figur 1 beschrieben, eine Maßnahme 22 im Lötprozess 24 in der Flussmittelauftragung 2 eingeleitet werden (negative Temperaturauswertung 46).

Bei der Betrachtung des Temperatur-Zeit-Verlaufs 26 gemäß Figur 3 wird mittels der Infrarotkamera 36 eine zeitabhängige Thermografie-Aufnahme 12 erstellt. Es wird demnach ein Thermografie-Video entlang des Zeitintervalls 23 aufgenommen. Eine zeitabhängige Aufnahme hat den Vorteil, dass eine detailliertere Bewertung des tatsächlichen Flussmittelauftrages und des Verdampfungsverhaltens vorgenommen werden kann. Die Entscheidung, ob genügend Flussmittel 14 aufgetragen ist, die durch die Datenanalyse 40 erfolgt, kann somit sicherer getroffen werden, da es sich um einen längeren Zeitraum handelt. Grundsätzlich kann allerdings auch ein singulärer Zeitpunkt, beispielsweise zum Zeitpunkt t1, aufgenommen werden und eine Betrachtung erfolgen, ob der so aufgenommene Temperaturmesswert unterhalb des Schwellenwertes 20 liegt.

Der Vorteil des beschriebenen Verfahrens gegenüber dem Stand der Technik besteht also darin, dass die Erkenntnis über lokale Temperaturanomalien 18 aufgrund der Verdampfung von Flussmittelbestandteilen genutzt wird, um Rückschlüsse über die Menge des aufgetragenen Flussmittels 14 an definierten Orten, also den Flussmittelbenetzungsflächen 6, zu ermitteln und daraus ggf. qualitätssichernde Maßnahmen 22 für den Lötprozess 4 bzw. den Flussmittelauftrag 2 einzuleiten. Durch diese Erkenntnis und durch diese eingeleiteten Maßnahmen 22 kann die Qualität des gesamten Produktes, also der Leiterplatte 34, verbessert werden und eine Ausschussrate gesenkt werden.

### Bezugszeichenliste

- 2': Flussmittel
- 4: Lötprozess
- 6: Flussmittelbenutzungsfläche
- 8: Abbildung
- 10: Leiterplattformoberfläche
- 12: Thermographieaufnahme
- 14: Flussmittel
- 16: Justierpunkte
- 18: Temperaturanomalien
- 20: Temperaturschwellwerk
- 22: Maßnahme
- 23: Zeitintervall
- T: Temperatur
- 24: Referenzverlauf
- 26: betrachteten T-t Verlauf
- Z: definierte Flussmittelberechnungsfläche
- 28: Toleranzbereich
- 30: Computersystem
- 32: Transportband
- 34: Leiterplatte
- 36: Infrarotkamera
- 38: Lötanlage
- 40: Überlagerung Abbildung/Aufnahme
- 42: Auswertung
- 44: positive Temperaturauswertung
- 46: negative Temperaturauswertung
- 48: Datenanalyse

## Patentansprüche

1. Verfahren zur Überwachung eines Flussmittel-Auftrags (2) in einem Lötprozess (4) umfassend folgende Schritte:
- Festlegen von Flussmittelbenetzungsflächen (6) in Bezug auf eine Abbildung (8) einer Applikationsoberfläche (10)
- Erzeugen einer Thermographie-Aufnahme (12) von der selektiv mit flüssigen Flussmittel (14) versehenen Applikationsoberfläche (10),
**dadurch gekennzeichnet, dass**
- Festlegen von Justierpunkten (16) auf der Applikationsoberfläche (10), die auf der Abbildung (8) und auf der Thermographie-Aufnahme (12) identifizierbar sind,
- Überlagern der Abbildung (8) und der Thermographie-Aufnahme (12) anhand der Justierpunkte (16)
- Vergleichen der Position von Temperaturanomalien (18) auf der Applikationsoberfläche (10), die mittels der Thermographie-Aufnahme (12) identifiziert werden mit der Position der Flussmittelbenetzungsflächen (6) auf der Abbildung (8).

2. Verfahren nach Anspruch 1, **dadurch gekennzeichnet, dass** ein Temperaturschwellwert (20) für die Temperaturanomalien (18) festgelegt ist.

3. Verfahren nach Anspruch 2, **dadurch gekennzeichnet, dass** eine Maßnahme (22) zur Beeinflussung des Lötprozesses (4) eingeleitet wird, wenn innerhalb eines Zeitintervalls (23) nach Aufbringen des Flussmittels (14) eine mittels der Thermographie-Aufnahme (12) bestimmte Temperatur (T) an einer Flussmittelbenetzungsfläche (6) jenseits des Temperaturschwellwertes (20) liegt.

4. Verfahren nach Anspruch 3, **dadurch gekennzeichnet, dass** die Temperatur (T) als Funktion der Zeit t betrachtet wird.

5. Verfahren nach Anspruch 4, **dadurch gekennzeichnet, dass** ein Referenzverlauf (24) einer Temperatur-Zeit-Kurve an einer definierten Flussmittelbenetzungsfläche (Z) aufgenommen wird und mit dem betrachteten Temperatur-Zeit-Verlauf (26) verglichen wird.

6. Verfahren nach Anspruch 5, **dadurch gekennzeichnet, dass** ein Toleranzbereich (28) des Referenzverlaufs (24) definiert wird, und die Maßnahme (22) eingeleitet wird, wenn der betrachtete Temperatur-Zeit-Verlauf (26), außerhalb des Toleranzbereichs (28) liegt.

7. Verfahren nach Anspruch 3 bis 6, **dadurch gekennzeichnet, dass** die Maßnahme dann erfolgt, wenn die Temperatur T an der Flussmittelbenetzungsflächen (6) über dem Temperaturschwellwert (20) liegt.

8. Verfahren nach einem der vorhergehenden Ansprüchen, **dadurch gekennzeichnet, dass** die Thermographie-Aufnahme (12) eine Mehrzahl von derartigen Aufnahmen innerhalb eines Zeitraums umfasst.

9. Verfahren nach einem der Ansprüche 3 bis 8, **dadurch gekennzeichnet, dass** als Maßnahme (22) ein erneutes Auftragen des Flussmittels an der detektierten Flussmittelbenetzungsflächen eingeleitet wird.

10. Verfahren nach einem der Ansprüche 3 bis 9, **dadurch gekennzeichnet, dass** als Maßnahme (22) eine Reinigung von Flussmittel-Auftragsdüsen eingeleitet wird.

11. Verfahren nach einem der vorhergehenden Ansprüche, **dadurch gekennzeichnet, dass** die Abbildung eine lichtfotographische Aufnahme der zu beobachtenden Applikationsoberfläche ist.

## Claims

1. Method for monitoring a flux application (2) in a soldering process (4) comprising the following steps:
- defining flux wetting surfaces (6) in relation to an image (8) of an application surface (10)
- generating a thermographic recording (12) of the application surface (10) selectively provided with liquid flux (14), **characterised in that**
- defining adjustment points (16) on the application surface (10) which can be identified on the image (8) and on the thermographic recording (12),
- superimposing the image (8) and the thermographic recording (12) on the basis of the adjustment points (16)
- comparing the position of temperature anomalies (18) on the application surface (10), which are identified by means of the thermographic recording (12), with the position of the flux wetting surfaces (6) on the image (8).

2. Method according to claim 1, **characterised in that** a temperature threshold value (20) is set for the temperature anomalies (18).

3. Method according to claim 2, **characterised in that** a measure (22) for influencing the soldering process (4) is initiated if, within a time interval (23) after application of the flux (14), a temperature (T) determined by means of the thermographic recording (12) is on a flux wetting surface (6) beyond the temperature threshold value (20).

4. Method according to claim 3, **characterised in that** the temperature (T) is considered as a function of time t.

5. Method according to claim 4, **characterised in that** a reference profile (24) of a temperature-time curve is recorded on a defined flux wetting surface (Z) and is compared with the considered temperature-time profile (26).

6. Method according to claim 5, **characterised in that** a tolerance range (28) of the reference profile (24) is defined, and the measure (22) is initiated when the considered temperature-time profile (26') is outside the tolerance range (28).

7. Method according to claim 3 to 6, **characterised in that** the measure is taken when the temperature T on the flux wetting surfaces (6) is above the temperature threshold value (20).

8. Method according to one of the preceding claims, **characterised in that** the thermographic recording (12) comprises a plurality of such recordings within a period of time.

9. Method according to one of claims 3 to 8, **characterised in that** a renewed application of the flux to the detected flux wetting surfaces is initiated as a measure (22).

10. Method according to one of claims 3 to 9, **characterised in that** a cleaning of flux application nozzles is initiated as a measure (22).

11. Method according to one of the preceding claims, **characterised in that** the image is a photographic recording of the application surface to be observed.

## Revendications

1. Procédé de surveillance d'une application de fondant (2) dans un procédé de brasage (4), comprenant les étapes ci-dessous consistant à :
- définir des surfaces de mouillage par fondant (6) par rapport à une image (8) d'une surface d'application (10),
- créer un enregistrement thermographique (12) de la surface d'application (10) munie de manière sélective de fondant liquide (14),
**caractérisé par** les étapes ci-dessous consistant à :
- définir des points d'ajustement (16) sur la surface d'application (10), qui peuvent être identifiés sur l'image (8) et sur l'enregistrement thermographique (12),
- superposer l'image (8) et l'enregistrement thermographique (12) à l'aide des points d'ajustement (16),
- comparer la position d'anomalies de température (18) sur la surface d'application (10), qui sont identifiées au moyen de l'enregistrement thermographique (12), avec la position des surfaces de mouillage par fondant (6) sur la figure (8).

2. Procédé selon la revendication 1, **caractérisé en ce qu'**une valeur de seuil de température (20) est définie pour les anomalies de température (18).

3. Procédé selon la revendication 2, **caractérisé en ce qu'**une mesure (22) est mise en œuvre afin d'influencer le procédé de brasage (4) si, dans un intervalle de temps (23) qui suit l'application du fondant (14), une température (T) déterminée au moyen de l'enregistrement thermographique (12) au niveau d'une surface de mouillage par fondant (6) se situe au-delà de la valeur de seuil de température (20).

4. Procédé selon la revendication 3, **caractérisé en ce que** la température (T) est considérée comme une fonction du temps t.

5. Procédé selon la revendication 4, **caractérisé en ce qu'**une courbe de référence (24) d'une courbe température-temps est enregistrée au niveau d'une surface de mouillage par fondant (Z) définie et est comparée à la courbe température-temps (26) considérée.

6. Procédé selon la revendication 5, **caractérisé en ce qu'**une plage de tolérance (28) de la courbe de référence (24) est définie, et la mesure (22) est mise en œuvre lorsque la courbe température-temps (26) considérée se situe en dehors de la plage de tolérance (28).

7. Procédé selon l'une quelconque des revendications 3 à 6, **caractérisé en ce que** la mesure intervient lorsque la température T au niveau des surfaces de mouillage par fondant (6) est supérieure à la valeur de seuil de température (20).

8. Procédé selon l'une quelconque des revendications précédentes, **caractérisé en ce que** l'enregistrement thermographique (12) comprend une pluralité de tels enregistrements sur une période de temps.

9. Procédé selon l'une quelconque des revendications 3 à 8, **caractérisé en ce que** la mesure (22) mise en œuvre est une nouvelle application du fondant sur les surfaces de mouillage par fondant détectées.

10. Procédé selon l'une quelconque des revendications 3 à 9, **caractérisé en ce que** la mesure (22) mise en œuvre est un nettoyage des buses d'application de fondant.

11. Procédé selon l'une quelconque des revendications précédentes, **caractérisé en ce que** l'image est un enregistrement photogrammétrique de la surface d'application à observer.
